(19) Europäisches Patentamt
European Patent Office
Office européen des brevets

(11) **EP 1 486 987 B1**

(12) **FASCICULE DE BREVET EUROPEEN**

(45) Date de publication et mention
de la délivrance du brevet:
**13.05.2009 Bulletin 2009/20**

(51) Int Cl.:
***G11C 16/34*** *(2006.01)*

(21) Numéro de dépôt: **04013056.9**

(22) Date de dépôt: **03.06.2004**

(54) **Memoire flash comprenant des moyens de contrôle et de rafraîchissement de cellules mémoire dans l'état effacé**

Flash-Speicher mit Mitteln zum Steuern und Auffrischen von Speicherzellen im gelöschten Zustand

Flash memory comprising means for controlling and refreshing memory cells in the erased state

(84) Etats contractants désignés:
**DE FR GB IT**

(30) Priorité: **12.06.2003 FR 0307052**

(43) Date de publication de la demande:
**15.12.2004 Bulletin 2004/51**

(73) Titulaire: **STMicroelectronics SA**
**92210 Montrouge (FR)**

(72) Inventeurs:
- **Leconte, Bruno**
  **13790 Rousset (FR)**
- **Cavaleri, Paola**
  **13790 Rousset (FR)**
- **Zink, Sébastien**
  **13090 Aix en Provence (FR)**

(74) Mandataire: **Kühn, Armin**
**Viering, Jentschura & Partner**
**Postfach 22 14 43**
**80504 München (DE)**

(56) Documents cités:
**EP-A- 1 233 421          EP-A- 1 271 552**
**US-A- 5 274 599          US-A- 5 400 287**
**US-A- 5 633 823          US-B1- 6 240 032**
**US-B1- 6 515 910**

- **DATABASE WPI Section EI, Week 200107 Derwent Publications Ltd., London, GB; Class U14, AN 2001-057886 XP002271420 & KR 2000 010 421 A (HYUNDAI ELECTRONICS IND CO LTD) 15 février 2000 (2000-02-15)**

## Description

La présente invention concerne les mémoires Flash, et plus particulièrement une mémoire Flash effaçable par page du type décrit par la demande internationale WO 02/41322, comprenant des moyens de contrôle et de rafraîchissement de cellules mémoire dans l'état programmé.

Les cellules mémoire de mémoire Flash se distinguent des cellules mémoire de mémoire EEPROM par le fait qu'elles ne comprennent pas de transistors d'accès. De ce fait, dans un plan mémoire Flash, les transistors à grille flottante des cellules mémoire sont directement reliés aux lignes de bit du plan mémoire.

Une autre particularité des mémoires Flash est que les cellules mémoire sont dépourvues de transistor de contrôle de grille. De ce fait, lorsqu'une tension d'effacement est appliquée sur une ligne de mot, les grilles de contrôle de tous les transistors à grille flottante reçoivent cette tension. Ainsi, l'opération d'effacement dans une mémoire Flash est une opération collective qui concerne au moins toutes les cellules mémoire d'une même ligne de mot (page). Dans le cas d'un effacement par le canal, l'effacement concerne toutes les cellules mémoire d'un même secteur (cellules mémoire ayant un substrat commun, formé dans un caisson de type P) à moins de mettre en oeuvre un procédé d'effacement sélectif par page décrit dans la demande internationale précitée.

Leurs cellules mémoire étant ainsi dépourvues de transistor d'accès et de transistor de contrôle de grille, les mémoires Flash offrent une grande densité d'intégration en terme de nombre de cellules mémoire par unité de surface de silicium.

Cette simplification de la structure des cellules mémoire entraîne toutefois divers inconvénients, notamment un phénomène de stress de programmation.

En effet la programmation d'une cellule mémoire est une opération qui comprend l'application, sur une ligne de bit à laquelle la cellule mémoire est reliée, d'une tension de programmation Vpp (tension de drain du transistor à grille flottante). Or, tous les transistors à grille flottante reliés à la ligne de bit concernée reçoivent la tension Vpp puisqu'ils sont dépourvus de transistor d'accès. Ceci entraîne un stress électrique appelé stress de programmation ou stress de drain.

Ce stress de drain est particulièrement gênant dans une mémoire Flash effaçable par page du type décrit par la demande internationale précitée. En effet la prévision d'une mémoire Flash effaçable par page n'a d'intérêt que si l'on offre à l'utilisateur la possibilité d'effacer et de reprogrammer une même page un grand nombre de fois, sans se préoccuper des autres pages de la mémoire. Or, lorsque l'utilisateur applique des cycles d'effacement et de programmation successifs aux cellules mémoire d'une même page, les cellules mémoire des autres pages reçoivent répétitivement sur leurs drains la tension de programmation, ce qui entraîne une altération progressive des charges électriques piégées dans leurs grilles flottantes et peut conduire à une corruption de données.

Pour pallier cet inconvénient, la demande internationale précitée propose un procédé de rafraîchissement en programmation ("program refresh") comprenant une étape de contrôle cyclique des pages de la mémoire, et une étape de rafraîchissement des cellules mémoire programmées ayant perdu des charges électriques. Ce rafraîchissement consiste en une reprogrammation des cellules mémoire et permet d'éviter que ces cellules mémoire ne basculent progressivement dans l'état effacé.

La présente invention se fonde sur la constatation selon laquelle le phénomène de stress électrique a non seulement pour effet de déprogrammer des cellules mémoire dans l'état programmé (leur faire perdre des charges électriques) mais affecte également les cellules mémoire dans l'état effacé. On constate en effet que des charges électriques sont lentement piégées dans les grilles flottantes des cellules mémoire effacées, qui tendent progressivement vers l'état programmé. Ce phénomène est plus lent que le phénomène de "déprogrammation" de cellules mémoire programmées, mais peut entraîner une corruption de données après des milliers de cycles de stress électrique.

La présente invention vise à pallier cet inconvénient.

A cet effet, une première idée de la présente invention est de prévoir des cycles de rafraîchissement de cellules mémoire effacées, par analogie avec les cycles de rafraîchissement de cellules mémoire programmées décrits dans la demande internationale précitée.

Toutefois, s'il est techniquement possible de reprogrammer individuellement des cellules mémoire programmées ayant perdu des charges électriques, il semble au premier abord impossible de rafraîchir (ré-effacer) des cellules mémoire effacées ayant reçu une injection parasite de charges électriques. En effet, la programmation est une opération sélective, qui comprend l'application d'une tension de programmation aux lignes de bit des cellules mémoire à programmer, grâce à des verrous de programmation sélectionnables individuellement, tandis que l'effacement est une opération collective, comme rappelé ci-dessus, qui concerne au moins toutes les cellules mémoire d'une même ligne de mot sinon toutes les cellules mémoire d'un même secteur.

De ce fait, un rafraîchissement sélectif en effacement n'est pas envisageable avec un procédé d'effacement classique de cellules mémoire Flash. Si une page comprend des transistors programmés devant être rafraîchis en programmation et des transistors effacés devant être rafraîchis en effacement, les transistors programmés peuvent être rafraîchis individuellement mais les transistors effacés ne peuvent être rafraîchis individuellement au risque d'effacer les transistors programmés de la page. C'est pourquoi la demande internationale précitée ne propose qu'un rafraîchissement en programmation.

Ainsi, un autre objectif de la présente invention est de prévoir, dans une mémoire où toutes les cellules mémoire d'une page sont effacées collectivement, un procédé d'effacement sélectif permettant de rafraîchir individuellement des cellules mémoire dans l'état effacé sans effacer des cellules mémoire se trouvant dans l'état programmé.

Les préambules des revendications indépendantes 1, 5 et 14 sont basés su le document WO 02 /41322.

Cet objectif est atteint par les revendications indépendantes 1, 5 et 14.

Ces objets, caractéristiques et avantages ainsi que d'autres de la présente invention seront exposés plus en détail dans la description suivante du procédé de rafraîchissement en effacement selon l'invention et d'un exemple de mise en oeuvre de ce procédé dans une mémoire Flash effaçable par page, faite à titre non limitatif en relation avec les figures jointes parmi lesquelles :

- la figure 1 est une vue en coupe schématique de deux transistors à grille flottante de mémoire Flash,
- la figure 2 illustre schématiquement la mise en oeuvre d'un procédé d'effacement de page dans une mémoire Flash,
- la figure 3 illustre schématiquement la mise en oeuvre d'un procédé de programmation sélective de transistor à grille flottante dans une mémoire Flash,
- la figure 4 illustre l'effet du stress électrique de programmation dans des courbes de distribution statistique de tensions de seuil de transistors à grille flottante dans l'état programmé,
- la figure 5 illustre l'effet du stress électrique de programmation dans des courbes de distribution statistique de tensions de seuil de transistors à grille flottante dans l'état effacé,
- les figures 6A, 6B illustrent un procédé de rafraîchissement selon l'invention de transistors à grille flottante se trouvant dans l'état effacé,
- la figure 7 représente sous forme de blocs l'architecture d'une mémoire Flash mettant en oeuvre le procédé de rafraîchissement selon l'invention,
- la figure 8 représente l'architecture d'un circuit de contrôle représenté sous forme de bloc en figure 7, et
- la figure 9 représente l'architecture d'un compteur de contrôle et de rafraîchissement présent dans la mémoire de la figure 7

On décrira dans ce qui suit un procédé de rafraîchissement de cellules mémoire dans l'état effacé (rafraîchissement en effacement ou "erase refresh"). Ce procédé est destiné à être préférentiellement mis en oeuvre dans une mémoire Flash dans laquelle les cellules mémoire d'une même page sont effacées collectivement et programmées individuellement, et sont rafraîchies en programmation.

A titre de rappel et pour une bonne compréhension du contexte dans lequel s'inscrit la présente invention, on décrira tout d'abord un procédé classique d'effacement collectif des cellules mémoire d'une page, un procédé classique de programmation sélective de cellules mémoire, et un procédé classique de rafraîchissement de cellules mémoire dans l'état programmé (rafraîchissement en programmation ou "program refresh").

**Effacement collectif de cellules mémoire**

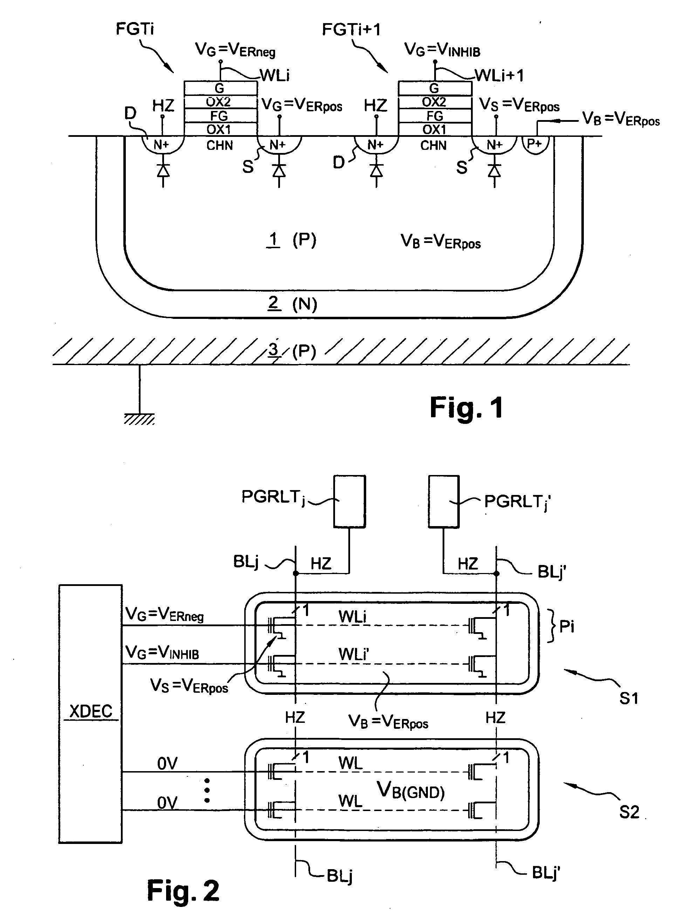

La figure 1 est une vue en coupe de deux transistors à grille flottante FGTi, FGTi+1 de type NMOS formant deux cellules mémoire Flash. Les transistors FGT sont réalisés dans un caisson 1 de type P implanté dans un caisson 2 de type N lui-même implanté dans un substrat 3 de type P. Chaque transistor comprend une grille flottante FG déposée sur le caisson 1 par l'intermédiaire d'une couche d'oxyde tunnel OX1, et une grille de contrôle G déposée sur la grille flottante FG par l'intermédiaire d'une autre couche d'oxyde OX2. La région de canal CHN de chaque transistor s'étend sous l'oxyde de grille OX1 et est délimitée par des régions de source et de drain de type N+ implantées dans le caisson 1. La grille de contrôle du transistor FGTi est reliée à une ligne de mot WLi et la grille de contrôle du transistor FGTi+1 est reliée à une ligne de mot WLi+1.

L'effacement d'un transistor à grille flottante consiste en une extraction de charges électriques piégées dans la grille flottantes, par effet tunnel (effet Fowler Nordheim). Pour effacer l'un des transistors, par exemple le transistor FGTi, le caisson 1 (soit le canal du transistor) est porté à une tension VB égale à une tension d'effacement positive VERpos, par exemple 9 V. Les sources sont portées à une tension VS qui est aussi égale à VERpos. Les régions de drain sont portées à haute impédance par un décodeur de colonne (non représenté) de sorte qu'une tension VD égale à [VERpos - 0,6V] apparaît sur ces régions, en raison de l'existence de jonctions canal/drain représentées schématiquement sous forme de diodes dans le sens passant. Une tension d'effacement négative VG = VERneg, par exemple -9 V, est appliquée à la grille de contrôle du transistor FGTi, tandis que la grille de contrôle du transistor FGTi+1 reçoit une tension d'inhibition VINHIB. La tension VINHIB est comprise entre 0V et 9 V mais est de préférence de 0 V pour simplifier l'architecture d'un décodeur de ligne de mot fournissant les tensions VINHIB et VERneg. La tension VINHIB compense tout ou partie du champ électrique créé par la tension VERpos et s'oppose à l'effacement du transistor FGTi+1.

La figure 2 illustre la mise en oeuvre de ce procédé d'effacement dans un plan mémoire Flash comprenant deux secteurs S1, S2, chaque secteur étant formé par un caisson P implanté dans un caisson N. Les drains des transistors à grille flottante de chaque secteur sont reliés à des lignes de bit BLj, BLj' qui sont elles-mêmes reliées à des verrous de programmation PGRLTj, PGRLTj'. Les grilles de contrôle des transistors à grille flottante sont reliées à des lignes de mot WLi, WLi' contrôlées par un décodeur de ligne de mot XDEC. L'isolement électrique des lignes de bit de même rang de chaque secteur, par exemple la ligne BLj du secteur S1 et la ligne BLj du secteur S2, est assuré par un décodage local au niveau des secteurs (non représenté).

Supposons que la page Pi du secteur S1 (ligne de mot WLi) doive être effacée sans effacer les autres pages du secteur S1 ni celles du secteur S2. Le caisson du secteur S1 et les sources des transistors du secteur sont portés à des tensions VS, VB égales à VERpos. Simultanément le décodeur XDEC fournit la tension d'effacement négative VERneg à la ligne de mot à effacer WLi et fournit la tension d'inhibition VINHIB aux autres lignes de mot WLi' du secteur S1. Ainsi, seuls les transistors de la page Pi sont effacés. Dans le secteur S2, toutes les lignes de bit BLj, BLj' sont portées à haute impédance, toutes les lignes de mot WL reçoivent une tension nulle (GND) et le caisson du secteur S2 est relié à la masse (GND). Les transistors du secteur S2 sont donc isolés des tensions d'effacement apparaissant dans le secteur S1.

Si l'on souhaite effacer collectivement tous les transistors du même secteur (transistors réalisés dans le même caisson), la tension d'effacement négative VERneg est simultanément appliquée sur toutes les lignes de mot du même secteur.

En définitive, l'effacement d'un transistor à grille flottante est une opération collective qui ne concerne que les transistors d'une même ligne de mot, dans le cas d'un effacement sélectif par page, ou concerne tous les transistors du caisson concerné dans le cas d'un effacement par secteur (application de la tension VERneg au lieu de la tension VINHIB sur toutes les lignes de mot du secteur).

Il n'est donc pas envisageable d'effacer individuellement un transistor à grille flottante en utilisant le processus d'effacement classique qui vient d'être décrit. Il est au contraire possible de programmer individuellement un tel transistor, comme rappelé ci-après, grâce aux verrous de programmation.

**Programmation sélective de cellules mémoire**

Dans une mémoire Flash, le processus de programmation s'effectue par injection d'électrons chauds et est applicable sélectivement à un ou plusieurs transistors.

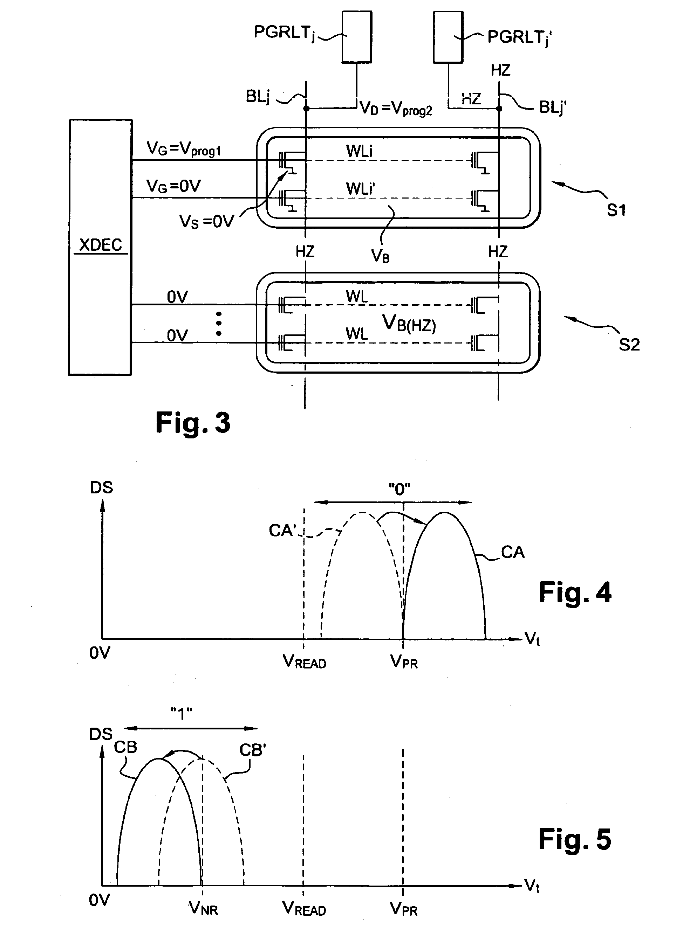

La figure 3 représente le même plan mémoire Flash que celui représenté en figure 2. Supposons qu'un transistor déterminé doive être programmé, par exemple le transistor relié à la ligne de bit BLj et la ligne de mot WLi du secteur S1.

Le décodeur XDEC applique à la grille de contrôle du transistor, par l'intermédiaire de la ligne de mot WLi, une tension de grille VG égale à une tension de programmation Vprog1 positive, par exemple 7,5 V. Le verrou de programmation PGRLTj applique au drain du transistor à programmer, par l'intermédiaire de la ligne de bit BLj, une tension de drain VD égale à une tension de programmation Vprog2, par exemple 4,5 V. La source du transistor est portée à une tension de source VS nulle et le caisson correspondant au secteur considéré est porté à la masse (VB = GND) ou à une tension sensiblement négative pour améliorer l'injection d'électrons chauds, par exemple -1,2 V. Le transistor recevant les tensions Vprog1 et Vprog2 est dans l'état passant et fortement polarisé, ce qui conduit à l'injection de charges électriques dans les grilles flottantes (état programmé).

Les transistors de la même ligne de mot qui ne sont pas à programmer, reçoivent la tension Vprog1 sur leurs grilles de contrôle mais ne reçoivent pas la tension Vprog2 sur leurs drains, car les lignes de bit BLj' correspondantes sont portées à haute impédance HZ par les autres verrous. La programmation est donc une opération sélective, car les tensions de programmation sont appliquées aux lignes de bit par des verrous de programmation qui sont sélectionnables individuellement.

La ligne de mot WLi' ne correspondant pas à la page où se trouvent les transistors à programmer reçoit une tension de grille VG nulle. De même, dans le secteur S2, toutes les lignes de bit sont portées à haute impédance (HZ) et toutes les lignes de mot sont à la masse.

Dans le secteur S1, les cellules mémoire de la ligne de mot WLi' qui sont reliées à la ligne de bit BLj reçoivent toutefois la tension de programmation Vprog2 et subissent un stress de programmation. Ces effets sont corrigés par le procédé de rafraîchissement en programmation décrit ci-après.

**Contrôle et rafraîchissement de cellules mémoire programmées**

La figure 4 représente la répartition statistique DS des tensions de seuil Vt de transistors programmés (courbe CA, lecture d'un 0). Sous l'effet du stress électrique, la courbe CA a tendance à se déplacer lentement vers la gauche, pour former une courbe CA'. Les transistors relevant de la courbe CA' ont perdu des charges électriques et présentent des tensions de seuil plus faibles que la normale. Une tension de lecture VREAD appliquée à la grille de contrôle de ces transistors, de l'ordre de 4,5V, se trouve à gauche des courbes CA, CA' et ne permet pas de distinguer un transistor relevant de la courbe CA ou un transistor relevant de la courbe CA'.

Selon l'enseignement divulgué par la demande internationale précitée, la tension de seuil de transistors programmés est contrôlée en appliquant aux grilles de contrôle des transistors, en tant que tension de lecture, une tension de contrôle VPR se trouvant entre les deux courbes CA, CA', par exemple 6,75 V. Cette tension permet de distinguer un transistor correctement programmé d'un transistor dont la grille flottante a perdu des charges électriques, car dans le premier cas le transistor est bloqué (lecture d'un 0, soit la valeur logique de programmation) et dans le second cas le transistor est passant (lecture d'un 1, soit la valeur logique d'effacement). La comparaison de données lues dans un groupe de transistors à grille flottante au moyen des deux tensions VREAD, VPR permet de détecter l'existence de transistors programmés dont les tensions de seuil sont devenues plus faibles que la tension VPR.

Si la comparaison montre que les données ne sont pas identiques, les données de référence lues avec la tension VREAD sont réenregistrées dans les transistors à grille flottante, au cours d'un cycle de programmation en soi classique formant un cycle de rafraîchissement. Au terme de ce cycle de rafraîchissement, la distribution statistique CA' se décale vers la droite et devient identique à la distribution statistique CA.

## Procédé de contrôle de cellules mémoire dans l'état effacé

Les observations exposées ci-après font partie intégrante de la présente invention.

La figure 5 représente la répartition statistique DS des tensions de seuil Vt de transistors effacés (courbe CB, lecture d'un 1). Sous l'effet du stress électrique, la courbe CB a tendance à se déplacer lentement vers la droite, pour former une courbe CB'. Les transistors relevant de la courbe CB' ont subi une injection parasite de charges électriques et présentent des tensions de seuil plus élevées que la normale. La tension de lecture VREAD se trouve à droite des courbes CB, CB' et ne permet pas de distinguer un transistor relevant de la courbe CB ou un transistor relevant de la courbe CB'.

On prévoit ainsi, selon l'invention, un contrôle de la tension de seuil des transistors effacés. Ce contrôle est effectué en appliquant aux grilles de contrôle de ces transistors, en tant que tension de lecture, une tension de contrôle VNR se trouvant entre les deux courbes CB, CB', par exemple 4,25 V. Cette tension permet de distinguer un transistor correctement effacé d'un transistor effacé dont la grille flottante a subi une injection parasite de charges électriques, car dans le premier cas le transistor est passant (lecture d'un 1) et dans le second cas le transistor est bloqué (lecture d'un 0).

Selon l'invention, des transistors à grille flottante sont lus par groupe de M transistors, par exemple 8, au moyen des deux tensions VREAD, VNR, et les données lues avec les deux tensions de lecture sont ensuite comparées. Si des transistors effacés présentent une tension de seuil plus élevée que la tension VNR, les données lues avec la tension VNR sont différentes des données de référence lues avec la tension VREAD. Celles-ci sont alors réenregistrées dans les transistors à grille flottante, au cours d'un cycle d'effacement sélectif selon l'invention, décrit ci-après. Ce cycle d'effacement sélectif forme un cycle de rafraîchissement de transistors à grille flottante endommagés. Au terme de ce cycle de rafraîchissement, la distribution statistique CB' se décale vers la gauche et devient identique à la distribution statistique CB.

## Procédé de rafraîchissement sélectif de cellules mémoire dans l'état effacé

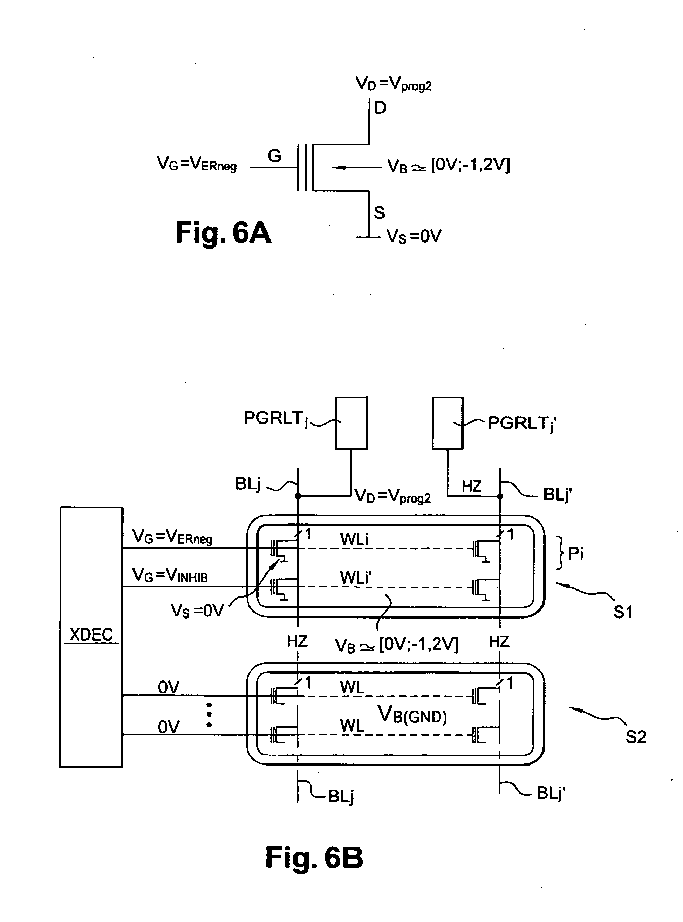

La figure 6A illustre les tensions appliquées aux bornes d'un transistor à grille flottante devant être rafraîchi conformément au procédé de l'invention. La tension de grille VG du transistor est classiquement portée à la valeur d'effacement négative VERneg.

L'idée de l'invention est d'appliquer une tension positive VD au drain du transistor au lieu d'appliquer la tension positive VERpos au canal et à la source du transistor. Il se produit alors, par effet tunnel, une extraction de charges depuis la grille flottante du transistor, portée à la tension VERneg, vers la source de tension positive à laquelle le drain est relié.

L'avantage de ce procédé d'effacement est que la tension de drain positive VD peut être fournie sélectivement par un verrou de programmation. La tension de drain positive VD est par exemple la tension de programmation Vprog2, ce qui évite de polariser les verrous de programmation avec une tension différente de celle utilisée pendant les cycles de programmation.

Simultanément, la source et le canal sont portés à des potentiels électriques n'interférant pas avec le mécanisme d'effet tunnel intervenant entre la grille de contrôle et le drain du transistor, par exemple les potentiels VS = VB = 0 V ou VS = 0 V et VB = -1,2 V.

La figure 6B représente le même plan mémoire Flash que celui représenté en figures 2 et 3. Supposons qu'un transistor déterminé doive être rafraîchi en effacement, par exemple le transistor relié à la ligne de bit BLj et la ligne de mot WLi du secteur S1.

Le décodeur de ligne de mot XDEC applique à la grille de contrôle du transistor, par l'intermédiaire de la ligne de mot WLi, la tension d'effacement VG = VERneg. Le verrou de programmation PGRLTj applique au drain du transistor à rafraîchir, par l'intermédiaire de la ligne de bit BLj, la tension de drain VD = Vprog2. La source du transistor est portée à une tension de source VS nulle et le caisson du secteur S1 est porté à la masse (VB = GND) ou à une tension sensiblement négative, par exemple - 1,2 V. La grille flottante du transistor perd des charges électriques par effet tunnel, comme expliqué ci-dessus.

Les transistors de la ligne de mot WLi ne devant pas être rafraîchis reçoivent la tension VERneg sur leurs grilles de contrôle mais ne reçoivent pas la tension Vprog2 sur leurs drains, car les lignes de bit BLj' correspondantes sont portées à haute impédance HZ par les verrous de programmation. Si ces transistors sont dans l'état effacé, ils ne sont pas rafraîchis, et s'ils sont dans l'état programmé, ils ne sont pas effacés.

En résumé le rafraîchissement selon l'invention est donc un processus d'effacement sélectif comparable au processus de programmation, car une tension d'effacement positive, par exemple la tension de programmation Vprog2 utilisée en tant que tension d'effacement, est appliquée par des verrous de programmation qui sont sélectionnables individuellement, ou par tout autre moyen équivalent permettant d'appliquer sélectivement aux lignes de bit une tension positive.

La ligne de mot WLi' ne correspondant pas à la page où se trouve le transistor à rafraîchir reçoit une tension de grille VG nulle. De même, dans le secteur voisin S2, toutes les lignes de bit sont portées à haute impédance (HZ) et toutes les lignes de mot sont à la masse.

## Exemple de mise en oeuvre du procédé de contrôle et de rafraîchissement selon l'invention

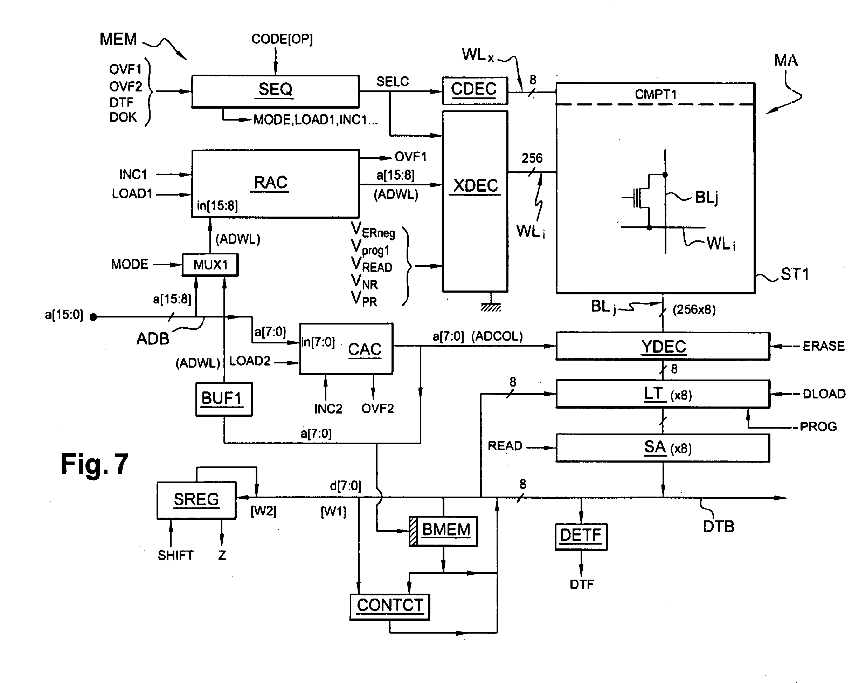

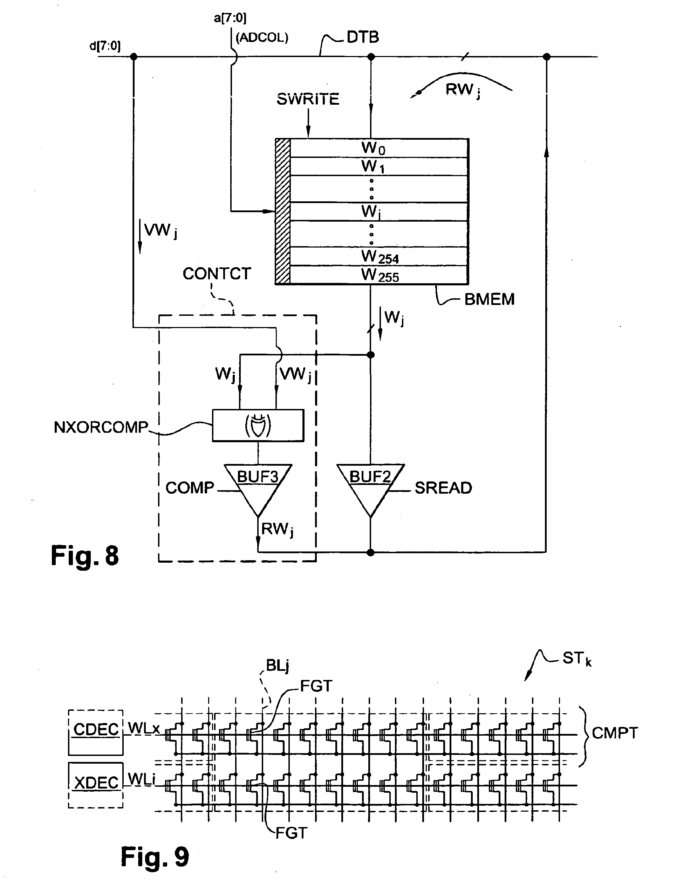

La figure 7 représente l'architecture générale d'une mémoire MEM1 comprenant des moyens de mise en oeuvre du procédé de contrôle et de rafraîchissement selon l'invention. La figure 8 représente plus en détail un élément de la mémoire.

## Architecture générale de la mémoire

La mémoire comprend un plan mémoire MA de type Flash comprenant au moins un secteur ST1 de 256 lignes de mot WLi et 2048 lignes de bit BLj (256x8), chaque ligne de mot comportant 256 mots de huit bits, ou octets. Le secteur ST1 comprend en outre une ligne de mot spéciale WLx dont les cellules mémoire forment un compteur CMPT1 permettant de gérer une adresse de page à contrôler et à rafraîchir.

Bien que cela ne soit pas représenté, la mémoire peut comprendre divers autres secteurs identiques, comprenant chacun une ligne de mot spéciale formant compteur.

La mémoire comprend un décodeur de ligne de mot XDEC pour piloter les lignes de mot WLi du secteur, et un décodeur spécifique CDEC pour piloter la ligne de mot WLx formant le compteur CMPT1. Le décodeur CDEC est activé par un signal de sélection SELC qui inhibe le décodeur XDEC.

En mode lecture de cellules mémoire, le décodeur XDEC peut recevoir l'une des trois tensions de lecture décrites plus haut, respectivement la tension de lecture VREAD, la tension de contrôle en programmation VPR et la tension de contrôle en effacement VNR. En mode effacement, le décodeur reçoit la tension d'effacement positive VERpos et en mode programmation le décodeur reçoit la tension de programmation Vprog1.

La mémoire comprend également un décodeur de colonne YDEC, un registre de programmation LT comprenant des verrous de programmation ("program latches"), un circuit de lecture SA comprenant des amplificateurs de lecture (sense amplifiers), un compteur d'adresse de ligne RAC, un compteur d'adresse de colonne CAC, un bus d'adresse ADB véhiculant une adresse de seize bits a[15:0] et un bus de données DTB véhiculant ici huit bits de données d[7:0] (M=8).

Le décodeur de colonne YDEC comprend 256 entrées/sorties de 8 bits reliées aux 256x8 lignes de bit du plan mémoire MA et huit entrées/sorties reliées au registre de programmation LT et au circuit de lecture SA.

Le registre LT comprend huit verrous haute tension (non représentés) permettant la programmation d'un octet dans le plan mémoire. Les verrous de programmation ont des sorties reliées aux lignes de bit du plan mémoire par l'intermédiaire des huit entrées/sorties du décodeur de colonne YDEC, et des entrées reliés au bus de données DTB, pour enregistrer des bits de données d[7:0] sur réception d'un signal DLOAD. Sur réception d'un signal de programmation PROG, la sortie de chaque verrou fournit la tension de programmation Vprog2 sur une ligne de bit sélectionnée par le décodeur YDEC, lorsque le bit qui a été chargé dans le verrou est égal à 0 (valeur logique de programmation). Dans le cas contraire, la sortie du verrou reste dans l'état haute impédance.

Le circuit de lecture SA comprend ici huit amplificateurs de lecture (non représentés) reliés en entrée aux huit entrées/sorties du décodeur de colonne YDEC, reliés en sortie au bus de données DTB, et activés par un signal READ.

Le compteur RAC (Row Address Counter) comporte des entrées in[15:8] pour recevoir huit bits d'adresse de poids fort a[15:8] présents sur le bus d'adresse ADB, formant une adresse de ligne de mot ADWL. La sortie du compteur RAC fournit l'adresse ADWL au décodeur de colonne XDEC. Le compteur RAC est piloté par un signal LOAD1 de chargement des bits d'adresse, peut être incrémenté par un signal INC1 et fournit un signal OVF1 en cas de débordement d'adresse.

Les bits d'adresse a[15:8] sont fournis au compteur RAC par l'intermédiaire d'un multiplexeur 8 bits MUX1 piloté par un signal MODE, ayant une entrée de 8 bits reliée au bus d'adresse ADB et une sortie de 8 bits reliée aux entrées in[15:8] du compteur RAC.

Le compteur CAC (Column Address Counter) comporte des entrées in[7:0] reliées au bus d'adresse ADB, pour recevoir 8 bits d'adresse de poids faible a[7:0] formant une adresse de colonne ADCOL. La sortie du compteur CAC fournit l'adresse de colonne ADCOL à une entrée d'adresse du décodeur YDEC. Le compteur CAC est piloté par un signal de chargement LOAD2, par un signal d'incrémentation INC2, et fournit un signal OVF2 égal à 1 lorsqu'il atteint la dernière adresse de colonne.

La mémoire comprend également un registre à décalage SREG de 8 bits à entrée/sortie parallèles, un détecteur logique DETF, un tampon BUF1 de 8 bits, une mémoire tampon BMEM, un circuit de contrôle CONTCT et un séquenceur SEQ.

Le registre SREG comporte une entrée et une sortie parallèles reliées au bus de données DTB, et est piloté par un signal de décalage SHIFT. Il fournit un signal Z égal à 1 lorsqu'il ne contient que des bits à 0.

Le détecteur DETF est relié en entrée au bus de données DTB pour recevoir les bits de données d[7:0]. Il fournit un signal DTF égal à 1 lorsque l'octet présent sur le bus de données est égal à FF (soit 11111111). Le signal DTF est de préférence à 1 lorsque le nombre de bits à 1 est majoritaire dans un octet analysé, afin de tolérer l'existence de cellules mémoire défaillantes dans le compteur.

Le tampon BUF1 présente une entrée recevant les bits d'adresse a[7:0] présents à la sortie du compteur CAC, formant l'adresse de colonne ADCOL, et une sortie reliée à une seconde entrée du multiplexeur MUX1. La seconde entrée du multiplexeur est reliée à la sortie du multiplexeur MUX1 quand le signal MODE est à 1.

La mémoire tampon BMEM et le circuit de contrôle CONTCT sont représentés plus en détail sur la figure 8. La mémoire tampon comporte une entrée d'adresse recevant les bits a[7:0] de l'adresse de colonne ADCOL fournie par le compteur CAC. Elle comporte une entrée de données reliée au bus DTB et enregistre un octet d[7:0] présent sur le bus sur réception d'un signal de chargement SWRITE. La mémoire tampon comporte également une sortie de données reliée au bus de données DTB par l'intermédiaire d'un tampon BUF2, dont l'état passant ou non passant est déterminé par un signal SREAD.

Le circuit CONTC comprend un comparateur 8 bits NXORCOMP comportant 8 portes logiques NON OU EXCLUSIF (NXOR, non représentées). Chaque porte logique comporte une première entrée reliée à la sortie de données de la mémoire tampon, et une seconde entrée reliée au bus de données DTB. Les sorties des portes logiques sont reliées au bus de données DTB par l'intermédiaire d'un tampon BUF3 dont l'état passant ou non passant est déterminé par un signal COMP.

Enfin, le séquenceur SEQ, à logique câblée ou à microprocesseur, fournit l'ensemble des signaux de commande des éléments de la mémoire MEM1 et reçoit les signaux émis par ces éléments.

**Architecture du compteur CMPT1**

La figure 9 est une vue partielle du secteur ST1. Les cellules mémoire du compteur CMPT1 sont formées par des transistors à grille flottante FGT qui sont reliés par leurs grilles de contrôle à la ligne de mot spéciale WLx, et sont reliés par leurs drains aux lignes de bit BLj du secteur. On distingue, sous la ligne de mot WLx, une ligne de mot normale WLi du secteur, à laquelle sont reliées les grilles de contrôle des transistors à grille flottante d'une page du secteur (une page correspondant à une ligne de mot).

Le compteur CMPT1 comporte ainsi ici 2048 bits, soit 256 colonnes de huit bits chacune, et est dédié à la gestion des adresses de lignes de mot à contrôler.

Le secteur comprenant ici 256 lignes de mot et le compteur comprenant 2048 cellules mémoire, le nombre de cellules mémoire pour former un jeton du compteur, tout en utilisant l'ensemble des cellules mémoire du compteur, est égal ici à 2048:256 soit 8 cellules mémoire, soit 256 jetons disponibles dans le compteur, affectés chacun à la désignation d'une page, le compteur étant effacé après contrôle et rafraîchissement de toutes les pages du secteur.

Tableau 1

| Etat du compteur | Adresse de la ligne de mot WLi à contrôler |
| --- | --- |
| FFFFFFFFFFFFF...FFFFFFFFFFFF | WL0 |
| 00FFFFFFFFFFF...FFFFFFFFFFFF | WL1 |
| 0000FFFFFFFFF...FFFFFFFFFFFF | WL2 |

(suite)

| Etat du compteur | Adresse de la ligne de mot WLi à contrôler |
|---|---|
| ... | ... |
| 0000000000000...000000000FF | WL255 |

Le remplissage du compteur CMPT1 s'effectue de la façon décrite par le tableau 1. Les données sont exprimées en notation hexadécimale (un caractère de 0 à F représentant 4 bits), la lecture d'une cellule mémoire dans l'état programmé correspond à la lecture d'un bit à 0, et la lecture d'une cellule mémoire effacée correspond à la lecture d'un bit à 1. Le compteur est programmé octet par octet, à commencer par les octets de poids faible, un octet représentant un jeton et l'adresse de l'octet dans le compteur représentant l'adresse d'une ligne de mot à contrôler.

**Fonctionnement général de la mémoire**

La mémoire fonctionne de façon classique pendant des opérations de lecture ou d'écriture de pages du plan mémoire. Les opérations à effectuer sont communiquées au séquenceur sous forme de codes opération CODE[OP]. Le signal MODE est à 0 et le multiplexeur MUX1 relie le bus d'adresse ADB aux entrées in[15:8] du compteur RAC. Lorsque des données doivent être écrites dans une page du secteur ST1, l'adresse de la page est fournie au compteur RAC via le bus d'adresse. Les données à enregistrer sont chargées tout d'abord dans la mémoire tampon BMEM (signal SWRITE) afin de simuler un mode de programmation par page (enregistrement en rafale d'une suite de mots). Ensuite, la page est effacée et les données sont lues octet par octet dans la mémoire tampon (signal SREAD) et enregistrées octet par octet dans le plan mémoire Flash, grâce aux verrous de programmation du registre LT. Le compteur de colonne CAC est incrémenté après chaque programmation d'un octet, jusqu'à ce que toutes les cellules mémoire de la page soient programmées (seules étant programmées les cellules mémoire devant recevoir la valeur logique de programmation, ici 0).

**Lecture dans le compteur de l'adresse d'une page à contrôler**

Lorsque des données ont été enregistrées dans une page du secteur ST1, le séquenceur SEQ déclenche une étape de lecture du compteur CMPT1 visant à déterminer l'adresse de la page devant être contrôlée.
Le séquenceur met le signal MODE à 1, active le décodeur CDEC au moyen du signal SELC, met à zéro le compteur CAC et active le circuit de lecture SA (signal READ, tension de lecture VREAD). Le premier octet du compteur CMPT1 est fourni sur le bus de données DTB par le circuit de lecture SA. Si le signal DTF à la sortie du circuit de détection DETF reste à 0, cela signifie que l'octet lu dans le compteur CMPT1 est nul. Le séquenceur incrémente alors le compteur CAC d'une unité, ce qui correspond à un saut d'un octet puisqu'une colonne électrique comprend ici huit lignes de bit. Le séquenceur lit l'octet suivant du compteur sur le bus de données, et ainsi de suite jusqu'à ce que le signal DTF passe à 1. Lorsque le signal DTF passe à 1, le séquenceur sait que l'octet lu est égal à FF. Il s'agit du premier octet non nul du compteur CMPT1.
L'adresse de colonne ADCOL (bits a[7:0]) présente à la sortie du compteur CAC représente l'adresse du premier octet non nul et correspond à la position du premier jeton non utilisé trouvé dans le compteur. Un jeton correspondant ici à huit bits de donnée, l'adresse de colonne ADCOL forme une adresse de ligne de mot ADWL (bits a[15:8]) qui désigne la page à rafraîchir. Il n'est pas nécessaire ici de convertir cette adresse de colonne en adresse de ligne de mot, puisqu'il existe une correspondance exacte entre les adresses colonne et les adresses de ligne de mot (chaque secteur comprenant 256 lignes de mot comportant chacune 256 octets, soit 256 colonnes électriques de huit lignes de bit chacune).
Ainsi, l'adresse ADCOL formant une adresse de ligne de mot ADWL désignant la page à contrôler est chargée dans le tampon BUF1 pour être ultérieurement fournie au compteur RAC, afin de contrôler la page désignée.

**Incrémentation du compteur**

L'incrémentation du compteur peut être faite immédiatement après la lecture du compteur et chargement de l'adresse ADWL dans le tampon BUF1. Avant d'incrémenter le compteur, le séquenceur contrôle la valeur du signal OVF2. Si ce signal est à 1, cela signifie que l'octet lu dans le compteur était le dernier octet du compteur CMPT1. Dans ce cas, le séquenceur sait que le compteur CMPT1 doit être effacé avant le prochain contrôle de page. Cet effacement peut être fait simultanément à l'effacement de la prochaine page à programmer (une programmation d'une page étant toujours précédée d'un effacement de la page).
Dans le cas contraire, le séquenceur incrémente le compteur CMPT1 d'une unité. Cette incrémentation consiste à mettre à 0 le premier octet non nul qui a été trouvé à l'étape de recherche de l'adresse de la page à contrôler. A cet effet, l'octet non nul présent dans le registre SREG est décrémenté par décalage à droite du registre et insertion de 0. Un jeton étant ici formé par 8 bits, un octet égal à FF correspondant à un jeton non utilisé est transformé en un octet égal à 0 correspondant à un jeton utilisé (soit 00 en notation hexadécimale). La valeur incrémentée de l'octet est ensuite chargée dans le registre LT via le bus de données DTB, et est enregistrée dans le compteur.

## Contrôle et rafraîchissement d'une page

L'adresse ADWL conservée dans le tampon BUF1 est appliquée sur les entrées in[15:8] du compteur RAC, par l'intermédiaire du multiplexeur MUX1, et le processus de contrôle de la page désignée par cette adresse est déclenché.

Le compteur CAC est remis à zéro et les octets de la page sont lus un par un pour être contrôlés et, si nécessaire, rafraîchis.

Ce contrôle comprend, selon l'invention, un contrôle de programmation et un contrôle d'effacement, pour respectivement rafraîchir les cellules mémoire programmées ayant perdu des charges électriques et tendant vers l'état effacé, et rafraîchir les cellules mémoire effacées ayant perdu des charges électriques et tendant vers un état programmé, comme cela a été décrit plus haut.

## Contrôle et rafraîchissement de cellules mémoire programmées

Après remise à zéro du compteur CAC, chaque octet de la page à contrôler est lu au moyen de deux tensions de lecture différentes, la première étant la tension de lecture VREAD et la seconde étant la tension de contrôle VPR supérieure à VREAD (Cf. Figure 4). La comparaison des octets lus au moyen des deux tensions VREAD, VPR permet de détecter les transistors à grille flottante dans l'état programmé dont la tension de seuil est devenue plus faible que la tension VPR.

Avantageusement, tous les octets de la page sont tout d'abord lus les uns après les autres avec la tension VREAD, et sont stockés dans la mémoire tampon. Ensuite, tous les octets de la page sont lus de nouveau les uns après les autres avec la tension de contrôle VPR et sont comparés avec les octets enregistrés dans la mémoire tampon BMEM. L'entrée d'adresse de la mémoire tampon étant ici pilotée par l'adresse de colonne ADCOL, il existe une correspondance exacte entre l'adresse de colonne d'un octet lu avec la tension de contrôle VPR et l'adresse dans la mémoire tampon de l'octet de référence lu avec la tension VREAD.

Un octet lu avec la tension de contrôle VPR est désigné VWj et un octet de référence enregistré dans la mémoire tampon est désigné Wj. L'octet VWj est présent sur le bus de données et est appliqué sur une entrée du comparateur NXORCOMP. L'octet de référence Wj lu dans la mémoire tampon est appliqué sur l'autre entrée du comparateur. La sortie du comparateur fournit, via le tampon BUF3 (signal COMP), un octet de rafraîchissement RWj qui est enregistré dans la mémoire tampon à la même adresse que l'octet de référence Wj initial.

Au terme du processus de comparaison octet par octet, la mémoire tampon BMEM ne comprend ainsi que des octets de rafraîchissement en programmation RWj. Chaque bit d'un octet de rafraîchissement est égal à 0 lorsque le bit lu avec la tension VPR n'a pas présenté la même valeur que le bit lu avec la tension VREAD, comme cela est décrit par le tableau 2. Une fois l'ensemble des octets de rafraîchissement chargés dans la mémoire tampon BMEM, celle-ci est lue octet par octet et chaque octet est enregistré dans la page à rafraîchir, par l'intermédiaire des verrous de programmation.

La tension de programmation Vprog1 est fournie à la ligne de mot concernée par le décodeur XDEC et les verrous de programmation fournissent la tension de programmation Vprog2 aux lignes de bit lorsqu'ils reçoivent un bit à 0, sinon ils restent dans l'état haute impédance (HZ). Le 0 est ainsi la valeur logique de rafraîchissement et le 1 la valeur logique de non-rafraîchissement. En d'autres termes, seuls sont reprogrammés les transistors à grille flottante dans lesquels des bits de valeurs différentes ont été lus au cours du processus de double lecture.

Tableau 2

| bit de référence lu avec VREAD | bit lu avec VPR | bit de rafraîchissement | Sortie du verrou de programmation |
|---|---|---|---|
| 0 | 1 | 0 (valeur active) | Vprog2 |
| 0 | 0 | 1 | HZ |
| 1 | 1 | 1 | HZ |
| 1 | 0 | cas impossible | - |

Dans le tableau 2, le cas "10" est impossible car les deux tensions VREAD, VPR sont supérieures aux limites des deux courbes de distribution CB, CB' de la figure 5. Ainsi, même si une cellule mémoire présente un état effacé dégradé nécessitant un rafraîchissement, cela n'affecte pas la lecture de la cellule mémoire avec chacune des deux tensions VREAD, VPR. L'état effacé dégradé d'une telle cellule mémoire sera détecté au cours d'une étape de contrôle et de rafraîchissement en effacement selon l'invention, qui sera maintenant décrite.

### Contrôle et rafraîchissement de cellules mémoire effacées

On a vu dans ce qui précède que le procédé de rafraîchissement sélectif en effacement selon l'invention est identique à un procédé de rafraîchissement sélectif en programmation classique, en ce qui concerne la tension de drain appliquée aux cellules mémoire à rafraîchir, celle-ci étant dans les deux cas fournie par un verrou de programmation.

Dans ces conditions, la gestion du rafraîchissement en effacement de transistors à grille flottante est sensiblement identique à la gestion du rafraîchissement en programmation.

Ainsi, après remise à zéro du compteur CAC, chaque octet de la page à contrôler est lu au moyen de deux tensions de lecture différentes, la première étant la tension de lecture VREAD et la seconde étant la tension de contrôle VNR inférieure à VREAD (Cf. Figure 5). La comparaison des octets lus au moyen des deux tensions VREAD, VNR permet de détecter les transistors à grille flottante dans l'état effacé dont la tension de seuil est devenue plus élevée que la tension VNR.

Comme précédemment, tous les octets de la page sont lus les uns après les autres au moyen de la tension VREAD et sont stockés dans la mémoire tampon. Ensuite, les octets de la page sont lus de nouveau les uns après les autres au moyen de la tension VNR et sont comparés avec les octets enregistrés dans la mémoire tampon BMEM.

Un octet lu avec la tension de contrôle VNR est de nouveau désigné VWj et un octet de référence enregistré dans la mémoire tampon est désigné Wj. L'octet VWj est présent sur le bus de données et est appliqué sur une entrée du comparateur NXORCOMP. L'octet de référence Wj lu dans la mémoire tampon est appliqué sur l'autre entrée du comparateur. La sortie du comparateur fournit, via le tampon BUF3, un octet de rafraîchissement RWj qui est enregistré dans la mémoire tampon à la même adresse que l'octet de référence Wj initial.

Au terme du processus de comparaison octet par octet, la mémoire tampon BMEM ne comprend que des octets de rafraîchissement en effacement. Chaque bit d'un octet de rafraîchissement est égal à 0 lorsque le bit lu avec la tension VNR n'a pas présenté la même valeur que le bit lu avec la tension VREAD, comme cela est décrit par le tableau 3 ci-après. Une fois l'ensemble des octets de rafraîchissement chargés dans la mémoire tampon BMEM, celle-ci est lue octet par octet et est enregistrée dans la page à rafraîchir, par l'intermédiaire des verrous de programmation. La tension d'effacement VERneg est fournie à la ligne de mot concernée par le décodeur XDEC et les verrous de programmation fournissent la tension de programmation Vprog2 (ici à des fins d'effacement) lorsqu'ils reçoivent un bit à 0, sinon les verrous restent dans l'état haute impédance.

Ainsi, ici également, le 0 est la valeur logique de rafraîchissement et le 1 la valeur logique de non-rafraîchissement. En d'autres termes, seuls sont rafraîchis en effacement les transistors à grille flottante ayant fourni des bits différents lors du processus de double lecture.

Dans le tableau 3, le cas "01" est impossible car les deux tensions VREAD, VNR sont supérieures aux limites des deux courbes de distribution CA, CA' de la figure 4. Ainsi, même si une cellule mémoire présente un état programmé dégradé nécessitant un rafraîchissement, cela n'affecte pas la lecture de la cellule mémoire avec chacune des deux tensions VREAD, VNR. En tout état de cause, l'état programmé dégradé d'une telle cellule mémoire est présumé avoir été corrigé au cours de l'étape de contrôle et de rafraîchissement en programmation décrite plus haut, si celle-ci est exécutée avant l'étape de rafraîchissement en effacement.

Tableau 3

| bit de référence lu avec VREAD | bit lu avec VPR | bit de rafraîchissement | Sortie du verrou de programmation |
|---|---|---|---|
| 1 | 0 | 0 (valeur active) | Vprog2 |
| 1 | 1 | 1 | HZ |
| 0 | 0 | 1 | HZ |
| 0 | 1 | cas impossible | - |

### Combinaison des étapes de programmation de pages et de contrôle de pages

On a décrit dans ce qui précède un exemple de mise en oeuvre du procédé de rafraîchissement selon l'invention, comprenant une étape de lecture du compteur, une étape d'incrémentation du compteur, une étape de contrôle des cellules mémoire programmées de la page désignée par le compteur, une étape de rafraîchissement en programmation des cellules mémoire nécessitant un tel rafraîchissement, une étape de contrôle des cellules mémoire effacées de la page et une étape de rafraîchissement des cellules mémoire effacées nécessitant un tel rafraîchissement.

En pratique, ce procédé permet de contrôler au moins une page désignée par le compteur après programmation d'au moins une page utilisateur, c'est-à-dire une page désignée par l'utilisateur et non par le compteur. De façon générale le procédé permet de contrôler N pages désignées par le compteur (en incrémentant N fois le compteur après chaque contrôle) après programmation de M pages du secteur, N et M étant des entiers supérieurs ou égaux à 1.

Diverses combinaisons d'étapes sont alors envisageables :

1) l'incrémentation du compteur intervient avant la programmation d'une page utilisateur mais le contrôle et le rafraîchissement d'une page intervient après la programmation de la page utilisateur. Dans ce cas, l'effacement du compteur, si nécessaire, est de préférence réalisé simultanément à l'effacement de la page utilisateur à programmer. De ce fait, l'effacement du compteur est une opération transparente pour l'utilisateur et n'entraîne aucun retard dans une succession d'étapes de programmation de pages,

2) l'incrémentation du compteur intervient après le contrôle et le rafraîchissement d'une page, et le contrôle et le rafraîchissement d'une page intervient après la programmation d'une page utilisateur,

3) l'incrémentation du compteur intervient avant le contrôle et le rafraîchissement d'une page, et le contrôle et le rafraîchissement d'une page interviennent avant la programmation d'une page utilisateur.

Il apparaîtra clairement à l'homme de l'art que le procédé selon l'invention est susceptible de diverses autres variantes de réalisation, notamment en fonction de l'architecture de la mémoire dans laquelle il est mis en oeuvre.

La mémoire peut notamment comprendre un bus de données de Nx8 bits avec lecture des octets par groupe de N dans les pages sélectionnées, notamment dans la page formant compteur. Dans ce cas, les adresses de colonne sont formées par des bits d'adresse de poids fort (par exemple a[7:1] si N=2) et les bits d'adresse de poids faible (par exemple a [0] si N=2) sont utilisés pour sélectionner en sortie de la mémoire, par exemple avec un multiplexeur, l'un des N octets lus. Un convertisseur d'adresse est alors nécessaire entre la sortie du compteur CAC et la seconde entrée du circuit MUX1, pour convertir l'adresse de colonne du groupe de N octets lus simultanément en une adresse de ligne de bit. Ce convertisseur recherche l'octet non nul dans le groupe de N octets et, si l'octet non nul est l'octet de rang n dans le groupe de N octets, ajoute la valeur n à l'adresse de colonne du groupe d'octets pour former l'adresse de la page à rafraîchir.

De façon générale, la valeur maximale de comptage (CMAX) d'un compteur selon l'invention peut être supérieure au nombre de lignes de mot dans un secteur. Si l'on considère, pour fixer les idées, l'exemple simplifié d'un secteur de 8 pages (X1 = 8) dans lequel deux pages à la fois (K = 2) sont contrôlées tous les quatre cycles (R = 4) de programmation de pages du secteur, il vient:

$$CMAX = X1*R/K = 16$$

Ainsi, un tel compteur peut compter jusqu'à seize, soit seize jetons utilisables, si un jeton correspond à une page et une seule, sans supporter un nombre de cycles de stress électrique supérieur à celui que peuvent supporter les autres pages du secteur. Si par contre un jeton est utilisé pour désigner simultanément P pages à contrôler, par exemple deux pages, en faisant intervenir une table de correspondance ou un convertisseur d'adresse, alors la valeur maximale de comptage ne doit pas être supérieure à CMAX/P soit 8 si P = 2.

Selon l'architecture de la mémoire utilisée, on peut également prévoir une gestion de compteur telle que, lorsque la valeur de comptage maximale est atteinte et que le compteur est effacé, le nombre maximal de cycles de stress électrique supporté par les cellules mémoire d'un compteur soit inférieur au nombre maximal de cycles de stress que peuvent subir les autres cellules mémoire d'un secteur.

Enfin, le terme verrou de programmation désigne de façon générale tout moyen permettant d'appliquer sélectivement une tension positive sur une ligne de bit. Ainsi, dans certaines mémoires, la fonction de verrouillage (soit la sélection d'une ligne de bit à partir d'une adresse déterminée) est intégrée dans le décodeur de colonne et les verrous de programmation ne sont que des adaptateurs de tension pour convertir une tension d'alimentation Vcc en tension de programmation Vprog2. Dans d'autres mémoires, la fonction de verrouillage et la fonction de conversion en tension sont entièrement intégrées dans le décodeur de colonne, de sorte que l'existence des verrous de programmation ne se déduit que par l'existence de la fonction de verrouillage et la fourniture de la tension Vprog2 à la sortie du décodeur.

Le procédé de contrôle et de rafraîchissement de cellules mémoire qui vient d'être décrit est particulièrement simple à mettre en oeuvre et nécessite peu de moyens matériels. Il est en outre quasiment transparent pour l'utilisateur car le temps de contrôle et de rafraîchissement d'une page est de l'ordre de 200µ s, à comparer avec le temps nécessaire à l'effacement préalable d'une page, de l'ordre de 5 ms, auquel s'ajoute un temps de l'ordre de 1 300 µs (256x5µs) pour la programmation des 256 octets d'une page.

**Revendications**

1.  Procédé d'effacement d'un transistor à grille flottante (FGTi), comprenant les étapes consistant à :

    - appliquer une tension d'effacement négative (VERneg) à une grille de contrôle du transistor à grille flottante,
    - appliquer une tension d'effacement positive collective (VERpos) aux sources d'un groupe de transistors à grille flottante incluant le transistor à effacer,

    **caractérisé en ce qu'**il comprend en outre une étape de rafraichissement en effacement du transistor dans l'état effacé, comprenant les étapes consistant à :

    - appliquer une tension d'effacement négative (VERneg) à la grille de contrôle du transistor à grille flottante, et
    - appliquer sélectivement une tension de rafraîchissement d'effacement positive (VD, Vprog2) au drain du transistor à grille flottante.

2.  Procédé selon la revendication 1, dans lequel la tension de rafraîchissement d'effacement positive (VD, Vprog2) est sélectivement fournie par un verrou de programmation (PGRLTj, PGRLTj') du transistor à grille flottante.

3.  Procédé selon la revendication 2, dans lequel la tension de rafraîchissement d'effacement positive est égale à une tension de programmation (Vprog2) fournie par le verrou lors d'une programmation du transistor à grille flottante.

4.  Procédé selon l'une des revendications 1 à 3, comprenant, avant l'étape de rafraîchissement, une étape de contrôle de la tension de seuil du transistor à grille flottante, l'étape de contrôle comprenant une étape de lecture du transistor avec une première tension de lecture (VREAD) et une étape de lecture du transistor avec une seconde tension de lecture (VNR) .

5.  Procédé d'effacement d'une page de mémoire Flash comprenant une pluralité de transistors à grille flottante (FGTi) reliés par leurs grilles de contrôle à une ligne de mot (WLi) commune, et reliés par leurs drains à des lignes de bit (BLj) différentes, la mémoire Flash comprenant des verrous de programmation (PGRLTj, PGRLTj') reliés aux lignes de bit pour appliquer sélectivement aux drains des transistors à grille flottante une tension de programmation (Vprog2), procédé comprenant les étapes consistant à :

    - appliquer une tension d'effacement négative (VERneg) à la ligne de mot,
    - appliquer collectivement une tension d'effacement positive (VERpos) aux sources des transistors à grille flottante de la page,

    **caractérisé en ce qu'**il comprend en outre une étape de rafraîchissement de transistors à grille flottante de la page se trouvant dans l'état effacé, l'étape de rafraîchissement comprenant les étapes consistant à :

    - appliquer une tension d'effacement négative (VERneg) à la ligne de mot (WLi), et
    - appliquer sélectivement une tension de rafraîchissement d'effacement positive (VD, Vprog2) aux lignes de bit reliées aux drains de transistors à grille flottante devant être rafraîchis.

6.  Procédé selon la revendication 5, dans lequel la tension de rafraîchissement d'effacement positive (VD, Vprog2) est sélectivement fournie par des verrous de programmation (PGRLTj , PGRLTj ') .

7.  Procédé selon la revendication 6, dans lequel la tension de rafraîchissement d'effacement positive est égale à la tension de programmation (Vprog2).

8.  Procédé selon l'une des revendications 5 à 7, comprenant, avant l'étape de rafraîchissement, une étape de contrôle de la tension de seuil des transistors à grille flottante de la page, l'étape de contrôle comprenant une étape de lecture des transistors avec une première tension de lecture (VREAD) appliquée à la ligne de mot, et une étape de lecture des transistors avec une seconde tension de lecture (VNR) appliquée à la ligne de mot, un transistor n'étant rafraîchi que si deux bits lus dans le transistor avec les deux tensions de lecture, présentent des valeurs différentes.

**9.** Procédé selon la revendication 8 et l'une des revendications 5 à 7, dans lequel le contrôle et le rafraîchissement d'une page comprend les étapes suivantes :

i) lecture de tous les transistors de la page avec une première tension de lecture (VREAD), par groupe de M transistors, et chargement dans une mémoire tampon (BMEM) de groupes de M bits lus avec la première tension de lecture,
ii) lecture d'un groupe de M transistors de la page avec une seconde tension de lecture (VNR),
iii) combinaison logique bit à bit des M bits lus avec la seconde tension de lecture (VNR) et des M bits lus avec la première tension de lecture (VREAD) chargés dans la mémoire tampon,
iv) chargement dans la mémoire tampon de M bits formant le résultat de la combinaison logique,
v) répétition des étapes ii), iii) et iv) pour chaque groupe suivant de M transistors, jusqu'à ce que la page soit entièrement contrôlée,
vi) chargement successif dans des verrous de programmation des groupes de M bits présents dans la mémoire tampon, chaque chargement étant accompagné d'une application de la tension d'effacement négative (VERneg) sur la ligne de mot et de l'activation des verrous de programmation.

**10.** Procédé selon la revendication 9, dans lequel la combinaison logique bit à bit est faite au moyen de portes logiques de type OU EXCLUSIF.

**11.** Procédé selon l'une des revendications 8 à 10, dans lequel l'adresse de la page à contrôler est fournie par un compteur non volatile (CMPT1) comprenant des cellules mémoire reliées à une ligne de mot spéciale (WLx) de la mémoire Flash.

**12.** Procédé selon l'une des revendications 8 à 10, dans lequel l'adresse de la page à contrôler est fonction de l'adresse de colonne du premier groupe de M cellules mémoire non programmées trouvé dans le compteur.

**13.** Procédé selon l'une des revendications 5 à 12, comprenant également une étape de contrôle et de rafraîchissement de transistors à grille flottante dans l'état programmé.

**14.** Mémoire Flash comprenant :

- on plan mémoire comprenant une pluralité de transistors à grille flottante (FGTi) reliés par leurs grilles de contrôle à des lignes de mot (WLi), et par leurs drains à des lignes de bit (BLj), les transistors reliés à une même ligne de mot formant une page du plan mémoire,
- des verrous de programmation (PGRLTj, PGRLTj') reliés aux lignes de bit pour appliquer sélectivement aux drains des transistors à grille flottante une tension de programmation (Vprog2),
- un compteur pour désigner l'adresse d'au moins une page à contrôler, et
- des moyens de contrôle de la tension de seuil de transistors à grille flottante dans l'état programmé d'une page désignée par le compteur, et de reprogrammation de transistors programmés ayant une tension de seuil inférieure à un premier seuil déterminé (VPR),

**caractérisée en ce qu'**elle comprend des moyens (BMEM, CONTCT, XDEC, SA) de contrôle de la tension de seuil de transistors à grille flottante dans l'état effacé de la page désignée par le compteur, et de rafraîchissement de transistors effacés ayant une tension de seuil supérieure à un second seuil déterminé (VNR), les moyens de rafraîchissement de transistors effacés étant agencée pour :

- appliquer une tension d'effacement négative (VERneg) à la ligne de mot (WLi) à laquelle les transistors effacés sont reliés, et
- appliquer sélectivement une tension de rafraîchissement d'effacement positive (VD, Vprog2) aux lignes de bit reliées aux drains de transistors à grille flottante devant être rafraîchis.

**15.** Mémoire selon la revendication 14, dans laquelle la tension de rafraîchissement d'effacement positive (VD, Vprog2) est fournie par des verrous de programmation (PGRLTj , PGRLTj').

**16.** Mémoire selon la revendication 15, dans laquelle la tension de rafraîchissement d'effacement positive est égale à la tension de programmation (Vprog2).

**17.** Mémoire selon l'une des revendications 14 à 16, dans laquelle les moyens de contrôle de la tension de seuil de transistors à grille flottante dans l'état effacé comprennent :

- des moyens (XDEC, SA) de lecture des transistors avec une première tension de lecture (VREAD),
- des moyens (XDEC, SA) de lecture des transistors avec une seconde tension de lecture (VNR), et
- des moyens (CONCT) de comparaison des données lues dans les transistors avec les deux tensions de lecture.

18. Mémoire selon l'une des revendications 14 à 17, dans laquelle les moyens de contrôle de la tension de seuil de transistors à grille flottante dans l'état effacé comprennent une mémoire tampon (BMEM) et un circuit de combinaison logique (CONTCT) et sont agencés pour:

i) lire tous les transistors de la page avec une première tension de lecture (VREAD) par groupe de M transistors, et charger dans la mémoire tampon (BMEM) des groupes de M bits lus avec la première tension de lecture (VREAD),
ii) lire un groupe de M transistors de la page avec une seconde tension de lecture (VNR),
iii) combiner bit à bit les M bits lus avec la seconde tension de lecture (VNR) et les M bits correspondants lus avec la première tension de lecture (VREAD) et chargés dans la mémoire tampon,
iv) charger dans la mémoire tampon les M bits formant le résultat de la combinaison logique,
v) répéter les étapes ii), iii) et iv) pour chaque groupe suivant de M transistors, jusqu'à ce que la page soit entièrement contrôlée,
vi) charger successivement dans des verrous de programmation des groupes de M bits présents dans la mémoire tampon, chaque chargement étant accompagné d'une application de la tension d'effacement négative (VERneg) sur la ligne de mot et d'une activation des verrous de programmation.

19. Mémoire selon la revendication 18, dans laquelle le circuit de combinaison logique (CONTCT) comprend des portes logiques de type OU EXCLUSIF.

20. Mémoire selon l'une des revendications 14 à 19, dans laquelle le compteur est un compteur non volatile (CMPT1) comprenant des cellules mémoire reliées à une ligne de mot spéciale (WLx) de la mémoire Flash.

**Claims**

1. Method for erasing a floating gate transistor (FGTi) comprising the steps of:

- applying a negative erasure voltage (VERneg) to a control gate of the floating gate transistor,
- applying a collective positive erasure voltage (VERpos) to the sources of a group of floating gate transistors including the transistor to be erased,

**characterised in that** it further comprises a step of refreshing during erasing of the transistor in the erased state, comprising the steps of:

- applying a negative erasure voltage (VERneg) to the control gate of the floating gate transistor and
- selectively applying a positive erasure refresh voltage (VD, Vprog2) to the drain of the floating gate transistor.

2. Method according to claim 1, wherein the positive erasure refresh voltage (VD, Vprog2) is selectively provided by a programming lock (PGRLTj, PGRLTj') of the floating gate transistor.

3. Method according to claim 2, wherein the positive erasure refresh voltage is equal to a programming voltage (Vprog2) which is provided by the lock during programming of the floating gate transistor.

4. Method according to any one of claims 1 to 3, comprising, before the refresh step, a step for controlling the threshold voltage of the floating gate transistor, the control step comprising a step for reading the transistor with a first reading voltage (VREAD) and a step for reading the transistor with a second reading voltage (VNR).

5. Method for erasing a page of flash memory comprising a plurality of floating gate transistors (FGTi) which are connected by the control gates thereof to a common word line (WLi) and which are connected by the drains thereof to different bit lines (BLj), the flash memory comprising programming locks (PGRLTj, PGRLTj') which are connected to the bit lines in order to selectively apply to the drains of the floating gate transistors a programming voltage (Vprog2), which method comprises the steps of:

- applying a negative erasure voltage (VERneg) to the word line,
- applying collectively a positive erasure voltage (VERpos) to the sources of the floating gate transistors of the page,

**characterised in that** it further comprises a step of refreshing floating gate transistors of the page which is in the erased state, the refresh step comprising the steps of:

- applying a negative erasure voltage (VERneg) to the word line (WLi), and
- selectively applying a positive erasure refresh voltage (VD, Vprog2) to the bit lines which are connected to the drains of floating gate transistors which have to be refreshed.

6. Method according to claim 5, wherein the positive erasure refresh voltage (VD, Vprog2) is selectively provided by programming locks (PGRLTj, PGRLTj').

7. Method according to claim 6, wherein the positive erasure refresh voltage is equal to the programming voltage (Vprog2).

8. Method according to any one of claims 5 to 7, comprising, before the refresh step, a step for controlling the threshold voltage of the floating gate transistors of the page, the control step comprising a step for reading the transistors with a first reading voltage (VREAD) which is applied to the word line, and a step for reading the transistors with a second reading voltage (VNR) which is applied to the word line, a transistor being refreshed only if two bits which are read from the transistor with the two reading voltages have different values.

9. Method according to claim 8 and any one of claims 5 to 7, wherein the control and refreshing of a page comprises the following steps:

i) reading all the transistors of the page with a first reading voltage (VREAD), for each group of M transistors, and loading in a buffer memory (BMEM) groups of M bits which are read with the first reading voltage,
ii) reading a group of M transistors of the page with a second reading voltage (VNR),
iii) logic combination bit by bit of the M bits which are read with the second reading voltage (VNR) and the M bits which are read with the first reading voltage (VREAD) and which are loaded in the buffer memory,
iv) loading in the buffer memory M bits forming the result of the logic combination,
v) repeating the steps ii), iii) and iv) for each subsequent group of M transistors until the page is completely controlled,
vi) successively loading in programming locks the groups of M bits which are present in the buffer memory, each loading operation being accompanied by an application of the negative erasure voltage (VERneg) to the word line and activation of the programming locks.

10. Method according to claim 9, wherein the bit by bit logic combination is carried out by means of logic gates of the EXCLUSIVE OR type.

11. Method according to any one of claims 8 to 10, wherein the address of the page to be controlled is provided by a non-volatile counter (CMPT1) which comprises memory cells which are connected to a special word line (WLx) of the flash memory.

12. Method according to any one of claims 8 to 10, wherein the address of the page to be controlled is dependent on the column address of the first group of M nonprogrammed memory cells in the counter.

13. Method according to any one of claims 5 to 12, further comprising a step for controlling and refreshing floating gate transistors in the programmed state.

14. Flash memory comprising:

- a memory plane which comprises a plurality of floating gate transistors (FGTi) which are connected by the control gates thereof to word lines (WLi) and by the drains thereof to bit lines (BLj), the transistors connected to the same word line forming a page of the memory plane,

- programming locks (PGRLTj, PGRLTj') which are connected to the bit lines in order to selectively apply to the drains of the floating gate transistors a programming voltage (Vprog2),
- a counter for designating the address of at least one page to be controlled and
- means for controlling the threshold voltage of floating gate transistors in the programmed state of a page which is designated by the counter and for reprogramming programmed transistors having a threshold voltage which is less than a first predetermined threshold (VPR),

**characterised in that** it comprises means (BMEM, CONTCT, XDEC, SA) for controlling the threshold voltage of floating gate transistors in the erased state of the page which is designated by the counter, and for refreshing erased transistors which have a threshold voltage greater than a second predetermined threshold (VNR), the means for refreshing erased transistors being arranged in order to:

- apply a negative erasure voltage (VERneg) to the word line (WLi) to which the erased transistors are connected and
- selectively apply a positive erasure refresh voltage (VD, Vprog2) to the bit lines which are connected to the drains of floating gate transistors which have to be refreshed.

15. Memory according to claim 14, wherein the positive erasure refresh voltage (VD, Vprog2) is provided by programming locks (PGRLTj, PGRLTj').

16. Memory according to claim 15, wherein the positive erasure refresh voltage is equal to the programming voltage (Vprog2).

17. Memory according to any one of claims 14 to 16, wherein the means for controlling the threshold voltage of floating gate transistors in the erased state comprise:

- means (XDEC, SA) for reading the transistors with a first reading voltage (VREAD),
- means (XDEC, SA) for reading the transistors with a second reading voltage (VNR), and
- means (CONCT) for comparing the data which are read from the transistors with the two reading voltages.

18. Memory according to any one of claims 14 to 17, wherein the means for controlling the threshold voltage of floating gate transistors in the erased state comprise a buffer memory (BMEM) and a logic combination circuit (CONTCT) and are arranged in order to:

i) read all the transistors of the page with a first reading voltage (VREAD) for each group of M transistors, and load in the buffer memory (BMEM) groups of M bits which are read with the first reading voltage (VREAD),
ii) read a group of M transistors of the page with a second reading voltage (VNR),
iii) combine bit by bit the M bits which are read with the second reading voltage (VNR) and the M corresponding bits which are read with the first reading voltage (VREAD) and which are loaded in the buffer memory,
iv) load in the buffer memory the M bits forming the result of the logic combination,
v) repeat the steps ii), iii) and iv) for each subsequent group of M transistors until the page is completely controlled,
vi) successively load in programming locks groups of M bits which are present in the buffer memory, each loading operation being accompanied by an application of the negative erasure voltage (VERneg) to the word line and activation of the programming locks.

19. Memory according to claim 18, wherein the logic combination circuit (CONTCT) comprises logic gates of the EXCLUSIVE OR type.

20. Memory according to any one of claims 14 to 19, wherein the counter is a non-volatile counter (CMPT1) which comprises memory cells which are connected to a special word line (WLx) of the flash memory.

**Patentansprüche**

1. Verfahren zum Löschen eines Floating-Gate-Transistors (FGTi), aufweisend die Schritte bestehend aus:

- Anlegen einer negativen Löschspannung (VERneg) an ein Steuerungs-Gate des Floating-Gate-Transistors,
- Anlegen einer kollektiven positiven Löschspannung (VERpos) an die Source-Anschlüsse einer Gruppe von Floating-Gate-Transistoren einschließlich des zu löschenden Transistors,

**dadurch gekennzeichnet, dass** es außerdem einen Schritt des Auffrischens der Löschung des Transistors im Löschzustand aufweist, welcher die Schritte aufweist bestehend aus:

- Anlegen einer negativen Löschspannung (VERneg) an das Steuerungsgate des Floating-Gate-Transistors, und
- Selektives Anlegen einer positiven Auffrischungsspannung (VD, Vprog2) der Löschung an den Drain-Anschluss des Floating-Gate-Transistors.

2. Verfahren nach Anspruch 1, wobei die positive Auffrischungsspannung (VD, Vprog2) der Löschung mittels einer Programmierzelle (PGRLTj, PGRLTj) des Floating-Gate-Transistors selektiv geliefert wird.

3. Verfahren nach Anspruch 2, wobei die positive Auffrischungsspannung der Löschung gleich einer Programmierspannung (Vprog2) ist, die von der Zelle während einer Programmierung des Floating-Gate-Transistors geliefert wird.

4. Verfahren nach einem der Ansprüche 1 bis 3, aufweisend nach dem Auffrischungsschritt einen Schritt zum Kontrollieren der Schwellenspannung des Floating-Gate-Transistors, wobei der Steuerungsschritt einen Schritt des Lesens des Transistors mit einer ersten Lesespannung (VREAD) und einen Schritt des Lesens des Transistors mit einer zweiten Lesespannung (VNR) aufweist.

5. Verfahren zum Löschen einer Seite eines Flashspeichers, aufweisend eine Vielzahl von Floating-Gate-Transistoren (FGTi), deren Steuerungs-Gates mit einer gemeinsamen Wortleitung (WLi) verbunden sind und deren Drain-Anschlüsse mit unterschiedlichen Bitleitungen (BLj) verbunden sind, wobei der Flashspeicher Programmierzellen (PGRLTj, PGRLTj') aufweist, die mit den Bitleitungen zum selektiven Anlegen einer Programmierspannung (Vprog2) an die Drain-Anschlüsse der Floating-Gate-Transistoren verbunden sind, wobei das Verfahren die Schritte aufweist bestehend aus:

- Anlegen einer negativen Löschspannung (VERneg) an die Wortleitung,
- Kollektives Anlegen einer positiven Löschspannung (VERpos) an die Source-Anschlüsse der Floating-Gate-Transistoren der Seite,

**dadurch gekennzeichnet, dass** es außerdem einen Schritt zum Auffrischen von Floating-Gate-Transistoren der Seite aufweist, die sich im Löschzustand befinden, wobei der Auffrischungsschritt die Schritte aufweist bestehend aus:

- Anlegen einer negativen Löschspannung (VERneg) an die Wortleitung (WLi), und
- Selektives Anlegen einer positiven
Auffrischungsspannung (VD, Vprog2) der Löschung an die Bitleitungen, die mit den Drain-Anschlüssen der Floating-Gate-Transistoren verbunden sind, bevor sie aufgefrischt werden.

6. Verfahren nach Anspruch 5, wobei die positive Auffrischungsspannung (VD, Vprog2) der Löschung selektiv von Programmierzellen (PGRLTj, PGRLTj') geliefert wird.

7. Verfahren nach Anspruch 6, wobei die positive Auffrischungsspannung gleich der Programmierspannung (Vprog2) ist.

8. Verfahren nach einem der Ansprüche 5 bis 7, aufweisend vor dem Auffrischungsschritt einen Schritt zum Kontrollieren der Schwellenspannung der Floating-Gate-Transistoren der Seite, wobei der Steuerungsschritt aufweist einen Schritt zum Lesen der Transistoren mit einer ersten Lesespannung (VREAD), die an die Wortleitung angelegt wird, und einen Schritt zum Lesen der Transistoren mit einer zweiten Lesespannung (VNR), die an die Wortleitung angelegt wird, wobei ein Transistor erst aufgefrischt ist, wenn zwei Bits in den Transistor mit den zwei Lesespannungen gelesen wurden, die zwei verschiedene Werte darstellen.

9. Verfahren nach Anspruch 8 und einem der Ansprüche 5 bis 7, wobei das Kontrollieren und das Auffrischen einer Seite die folgenden Schritte aufweist:

i) Lesen von allen Transistoren der Seite mit einer ersten Lesespannung (VREAD) in Gruppen von M Transistoren und Laden von Gruppen von M Bits, die mit der ersten Lesespannung gelesen wurden, in einen Pufferspeicher (BMEM),

ii) Lesen einer Gruppe von M Transistoren der Seite mit einer zweiten Lesespannung (VNR),

iii) Logisches bitweises Kombinieren der M Bits, die mit der zweiten Lesespannung (VNR) gelesen wurden, und der M Bits, die mit der ersten Lesespannung (VREAD) gelesen wurden, die in den Pufferspeicher geladen wurden,

iv) Laden von M Bits, die das Ergebnis der logischen Kombination bilden, in den Pufferspeicher,

v) Wiederholen der Schritte ii), iii) und iv) für jede nachfolgende Gruppe von M Transistoren, bis die Seite vollständig kontrolliert wurde,

vi) Schrittweises Laden der Gruppen von M Bits, die im Pufferspeicher vorhanden sind, in Programmierzellen, wobei jedes Laden mit einem Anlegen der negativen Löschspannung (VERneg) an die Wortleitung und dem Aktivieren der Programmierzellen verbunden ist.

10. Verfahren nach Anspruch 9, wobei die logische bitweise Kombination mittels Logikgatter vom Typ XOR durchgeführt wird.

11. Verfahren nach einem der Ansprüche 8 bis 10, wobei die Adresse der zu kontrollierenden Seite von einem nichtflüchtigen Zähler (CMPT1) geliefert wird, aufweisend Speicherzellen, die mit einer speziellen Wortleitung (WLx) des Flashspeichers verbunden sind.

12. Verfahren nach einem der Ansprüche 8 bis 10, wobei die Adresse der zu kontrollierenden Seite eine Funktion der Feldadresse der ersten Gruppe von M nicht programmierten Speicherzellen ist, die sich in dem Zähler befindet.

13. Verfahren nach einem der Ansprüche 5 bis 12, aufweisend auch einen Schritt des Kontrollierens und des Auffrischens der Floating-Gate-Transistoren im Programmierzustand.

14. Flashspeicher, aufweisend:

- eine Speicherebene, aufweisend eine Vielzahl von Floating-Gate-Transistoren (FGTi), deren Steuer-Gates mit Wortleitungen (WLi) verbunden sind, und deren Drain-Anschlüsse mit Bitleitungen (BLj) verbunden sind, wobei die Transistoren, die eine Seite der Speicherebene bilden, mit derselben Wortleitung verbunden sind,
- Programmierzellen (PGRLTj, PGRLTj'), die mit den Bitleitungen zum selektiven Anlegen einer Programmierspannung (Vprog2) an die Drain-Anschlüsse der Floating-Gate-Transistoren verbunden sind,
- einen Zähler zum Bestimmen der Adresse von mindestens einer zu kontrollierenden Seite, und
- Mittel zum Kontrollieren der Schwellenspannung der Floating-Gate-Transistoren im Programmierzustand einer durch den Zähler bestimmten Seite und zum Reprogrammieren von programmierten Transistoren, die eine Schwellenspannung haben, die unter einer ersten ermittelten Schwellenspannung (VPR) liegt,

gekennzeichnet dadurch, dass er Mittel (BMEM, CONTCT, XDEC, SA) zum Kontrollieren der Schwellenspannung von Floating-Gate-Transistoren im Löschzustand der Seite, die von dem Zähler bestimmt wurde, und zum Auffrischen von gelöschten Transistoren aufweist, die eine Schwellenspannung aufweisen, die höher ist als ein zweiter ermittelter Schwellenwert (VNR), wobei die Auffrischungsmittel von gelöschten Transistoren eingerichtet sind zum:

- Anlegen einer negativen Schwellenspannung (VERneg) an die Wortleitung (WLi), mit der die gelöschten Transistoren verbunden sind, und
- selektiven Anlegen einer positiven Auffrischungsspannung (VD, Vprog2) der Löschung an die Bitleitungen, die mit den Drain-Anschlüssen der Floating-Gate-Transistoren verbunden sind, bevor sie aufgefrischt werden.

15. Speicher nach Anspruch 14, wobei die positive Auffrischungsspannung (VD, Vprog2) der Löschung von Programmierzellen (PGRLTj, PGRLTj') geliefert wird.

16. Speicher nach Anspruch 15, wobei die positive Auffrischungsspannung der Löschung gleich der Programmierspannung (Vprog2) ist.

17. Speicher nach einem der Ansprüche 14 bis 16, wobei die Mittel zum Kontrollieren der Schwellenspannung von Floating-Gate-Transistoren im Löschzustand aufweisen:

- Mittel (XDEC, SA) zum Lesen der Transistoren mit einer ersten Lesespannung (VREAD),
- Mittel (XDEC, SA) zum Lesen der Transistoren mit einer zweiten Lesespannung (VNR), und

- Mittel (CONCT) zum Vergleichen der gelesenen Daten in den Transistoren mit den zwei Lesespannungen.

18. Speicher nach einem der Ansprüche 14 bis 17, wobei die Mittel zum Kontrollieren der Schwellenspannung von Floating-Gate-Transistoren im Löschzustand einen Pufferspeicher (BMEM) und eine Schaltung zum logischen Kombinieren (CONTCT) aufweisen und eingerichtet sind zum:

i) Lesen aller Transistoren der Seite mit einer ersten Lesespannung (VREAD) in einer Gruppe von M Transistoren, und Laden von Gruppen von M Bits, die mit der ersten Lesespannung (VREAD) gelesen wurden, in den Pufferspeicher (BMEM),

ii) Lesen einer Gruppe von M Transistoren der Seite mit einer zweiten Lesespannung (VNR),

iii) Bitweises Kombinieren der M Bits, die mit der zweiten Lesespannung (VNR) gelesen wurden, und der entsprechenden M Bits, die mit der ersten Lesespannung (VREAD) gelesen wurden und in den Pufferspeicher geladen wurden,

iv) Laden der M Bits, die das Ergebnis der logischen Kombination bilden, in den Pufferspeicher,

v) Wiederholen der Schritte ii), iii) und iv) für jede nachfolgende Gruppe von M Transistoren, bis die Seite vollständig kontrolliert wurde,

vi) Schrittweises Aufladen von Gruppen von M Bits, die in dem Pufferspeicher vorhanden sind, in Programmierzellen, wobei jedes Aufladen mit einem Anlegen der negativen Löschspannung (VERneg) an die Wortleitung und einem Aktivieren der Programmierzellen verbunden ist.

19. Speicher nach Anspruch 18, wobei der logische Kombinationsschaltkreis (CONTCT) Logikgatter vom Typ XOR aufweist.

20. Speicher nach einem der Ansprüche 14 bis 19, wobei der Zähler ein nichtflüchtiger Zähler (CMPT1) ist, der Speicherzellen aufweist, die mit einer speziellen Wortleitung (WLx) des Flashspeichers verbunden sind.

FGTi

$V_G = V_{ERneg}$

WLi

| G |
| OX2 |
| FG |
| OX1 |

D  HZ

$V_G = V_{ERpos}$

N+  CHN  N+

S

FGTi+1

$V_G = V_{INHIB}$

WLi+1

| G |
| OX2 |
| FG |
| OX1 |

HZ

$V_S = V_{ERpos}$

$V_B = V_{ERpos}$

D  N+  CHN  N+  P+

S

1 (P)

$V_B = V_{ERpos}$

2 (N)

3 (P)

**Fig. 1**

PGRLTj

PGRLTj'

BLj  HZ

HZ  BLj'

$V_G = V_{ERneg}$

WLi

Pi

$V_G = V_{INHIB}$

WLi'

$V_S = V_{ERpos}$

S1

XDEC

HZ  $V_B = V_{ERpos}$  HZ

0V  WL

$V_{B(GND)}$

0V  WL

S2

BLj  BLj'

**Fig. 2**

Fig. 3

Fig. 4

Fig. 5

$V_D = V_{prog2}$

D

$V_G = V_{ERneg}$ —— G

$V_B \simeq [0V; -1,2V]$

S

$V_S = 0V$

## Fig. 6A

PGRLT$_j$

PGRLT$_{j'}$

BL$_j$

$V_D = V_{prog2}$

HZ

BL$_{j'}$

XDEC

$V_G = V_{ERneg}$

$V_G = V_{INHIB}$

$V_S = 0V$

1  WL$_i$  1

WL$_{i'}$

} P$_i$

S1

HZ

$V_B \simeq [0V; -1,2V]$

HZ

0V

0V

1  WL

1

WL  $V_{B(GND)}$

S2

BL$_j$

BL$_{j'}$

## Fig. 6B

Fig. 7

EP 1 486 987 B1

**Fig. 8**

**Fig. 9**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0241322 A